# EUROPÄISCHE PATENTSCHRIFT

(11) **EP 1 239 710 B1**
(45) Veröffentlichungstag und Bekanntmachung des Hinweises auf die Patenterteilung: **20.08.2008**
(21) Anmeldenummer: 02003767.7
(22) Anmeldetag: 20.02.2002
(51) Int. Cl.: H05K 5/00, H05K 1/18

(54) **Elektronische Baugruppe**
Electronic assembly
Ensemble électronique

(30) Priorität: 06.03.2001 DE 10110620
(43) Veröffentlichungstag der Anmeldung: 11.09.2002
(73) Patentinhaber: Conti Temic microelectronic GmbH, 90411 Nürnberg (DE)
(72) Erfinder: Ende, Wolfgang, 90768 Fürth (DE); Fach, Hans-Joachim, 90427 Nürnberg (DE); Haas, Robert, 91056 Erlangen (DE); Liebl, Tilo, 91217 Hersbruck (DE); Pohlmann, Roger, 90765 Fürth (DE); Schmid, Thomas, 93049 Regensburg (DE); Thiel, Wolfgang, 85095 Denkendorf (DE); Werner, Bernhard, 90482 Nürnberg (DE)

(56) Entgegenhaltungen:
- DE-A1- 19 515 622
- DE-A1- 19 907 949
- DE-C1- 19 712 842

## Beschreibung

In vielen Bereichen werden elektronische Baugruppen für unterschiedliche Aufgaben und Anwendungen eingesetzt; insbesondere sind (bsp. im Kraftfahrzeugbereich zur Steuerung und/oder Regelung fahrspezifischer Vorgänge oder Abläufe) als elektronische Baugruppen Steuergeräte mit Sensoren zur Erfassung der Meßwerte physikalischer Größen, wie beispielsweise der Temperatur, der Drehzahl oder des Drucks und/oder mit Aktoren zur Betätigung von Stellgliedern gebräuchlich.
Die auf einem Trägerkörper angeordnete, elektronische Bauteile aufweisende Schaltungsanordnung der elektronischen Baugruppe ist üblicherweise von einem Gehäuse umgeben und zur Spannungsversorgung sowie zur Signalleitung (bsp. von Steuersignalen oder Meßsignalen zu oder von den elektronischen Bauteilen) über ein Stanzgitteranschlüsse aufweisendes Stanzgitter elektrisch leitend mit Sensoren und/oder Aktoren und/oder mit Anschlußsteckern verbunden.
Nachteilig bei diesen elektronischen Baugruppen ist, daß durch die große Teilevielfalt der Stanzgitter ein hoher Aufwand bei der Herstellung der elektronischen Baugruppe erforderlich ist (insbesondere zur Realisierung der Anschlußstecker), was wiederum hohe Kosten verursacht, und daß die Funktionsfähigkeit der Schaltungsanordnung und damit die Zuverlässigkeit der elektronischen Baugruppe beeinträchtigt werden kann, da (insbesondere bei bestimmten Einsatzbereichen der elektronischen Baugruppe, bsp. bei der Integration eines Getriebe-Steuergeräts in das Getriebe eines Kraftfahrzeugs) fluide Medien (bsp. Öl) aufgrund der Kapillarwirkung über die Anschlußstecker und die Stanzgitteranschlüsse des Stanzgitters in das Gehäuse der elektronischen Baugruppe eindringen können, wodurch die Störanfälligkeit bzw. Ausfallrate der elektronischen Bauteile der Schaltungsanordnung und damit der elektronischen Baugruppe erhöht wird.

DE 199 07 949 A1 beschreibt ein Steuergerät mit einem Gehäusedeckel und einer Bodenplatte. Der Gehäusedeckel und die Bodenplatte umschließen einen Hohlraum. In dem Hohlraum befindet sich eine elektronische Schaltung. Die elektronische Schaltung ist allseitig von einer flexiblen Leiterplatte umgeben. Dabei sind Leiterbahnen der flexiblen Leiterplatte über Banddrähte direkt über eine elektrische Kontaktklebung mit entsprechenden Kontaktpads auf dem Schaltungsträger verbunden. Die flexible Leiterplatte ist zu einzelnen, verteilt im Getriebe/Motor angeordneten Elektrobauteilen, wie Aktoren, Sensoren oder Steckern, hingeführt.

DE 197 12 842 C1 beschreibt ein Steuergerät mit einem Gehäusedeckel und einer Bodenplatte, wobei der Gehäusedeckel als Tragkörper für ein Steuergehäuse eines Automatikgetriebes ausgebildet ist. Ein derartiger Tragkörper ist auf einer Hydraulik-Schaltplatte befestigt und nimmt elektrische Leiter, Sensoren und einen Steckverbinder auf. Diese Komponenten liegen außerhalb des für eine Steuerelektronik oder elektronische Schaltung gebildeten Hohlraums. Die Leiter sind als Leitungsdrähte ausgebildet und mit Magnetspulen, einem Steckverbinder und Sensoren verbunden. Die Leitungsdrähte verlaufen im Gehäusedeckel von den außenliegenden Komponenten, wie Steckverbinder, Sensoren und dergleichen, in Richtung einer elektronischen Schaltung.

Der Erfindung liegt die Aufgabe zugrunde, eine elektronische Baugruppe mit einem einfachen Aufbau, einer einfachen Fertigung, geringen Kosten, einer hohen Zuverlässigkeit und vorteilhaften Eigenschaften bezüglich der elektrischen Verbindung anzugeben.
Diese Aufgabe wird nach der Erfindung durch die Merkmale des Patentanspruchs 1 gelöst.
Vorteilhafte Ausgestaltungen der Erfindung sind Bestandteil der übrigen Patentansprüche.

Als Bestandteil der elektronischen Baugruppe sind insbesondere folgende Komponenten vorgesehen:
- Ein aus einem Material mit hoher Wärmeleitfähigkeit bestehender Trägerkörper als Grundplatte für die elektronische Baugruppe; der Trägerkörper kann als Kühlkörper ausgebildet sein oder aber auf einem separaten Kühlkörper aus einem Material mit hoher Wärmeleitfähigkeit angeordnet werden.
- Ein Schaltungsträger mit einer elektronische Bauteile aufweisenden Schaltungsanordnung, der auf dem Trägerkörper aufgebracht ist; bsp. ist die Schaltungsanordnung als Hybridschaltung auf einem als Keramikträger ausgebildeten Schaltungsträger angeordnet, der auf den Trägerkörper aufgeklebt ist. Die Wärmeabfuhr der Schaltungsanordnung (der Verlustleistung der elektronischen Bauteile der Schaltungsanordnung) erfolgt über den Schaltungsträger und den Trägerkörper sowie ggf. über den Kühlkörper.
- Eine auf dem Trägerkörper angeordnete, (Verbindungs-)Leiterbahnen aufweisende Leiterfolie; diese bsp. auf den Trägerkörper auflaminierte Leiterfolie dient zur elektrischen Verbindung der Schaltungsanordnung mit weiteren elektronischen Bauteilen der elektronischen Baugruppe und/oder zur Verbindung der weiteren elektronischen Bauteile der elektronischen Baugruppe untereinander und/oder zur Realisierung von (externen) Verbindungsmöglichkeiten der elektronischen Baugruppe zu weiteren elektronischen Baugruppen. Bsp. sind für die Kontaktierung der elektronischen Bauteile der Schaltungsanordnung direkte Verbindungen (bsp. Bondverbindungen) von den Kontaktstellen der Leiterfolie zu den Anschlüssen der elektronischen Bauteile der Schaltungsanordnung vorgesehen, für die Kontaktierung der weiteren elektronischen Bauteile direkte Verbindungen oder indirekte Verbindungen von den Kontaktstellen der Leiterfolie zu den Anschlüssen der weiteren elektronischen Bauteile und für die externe Kontaktierung der elektronischen Baugruppe an Kontaktstellen der Leiterfolie angebrachte, in Anschlußstecker zusammengefaßte Anschlußkontakte. Die elektrisch leitende Verbindung zwischen den Kontaktstellen der Leiterfolie und den Anschlüssen der weiteren elektronischen Bauteile und/oder den Anschlußkontakten kann bsp. durch Löten, Schweißen oder Crimpen (formschlüssige Verbindung) realisiert werden.
- Ein auf den Trägerkörper aufgesetzter, bsp. aus Kunststoff bestehender Gehäusekörper, der zum Schutz gegen Umwelteinflüsse zumindest die Schaltungsanordnung mit deren elektronischen Bauteilen und einen Teilbereich der Leiterfolie sowie ggf. noch weitere elektronische Bauteile umschließt. Der sich innerhalb des Gehäusekörpers befindliche Teilbereich der Leiterfolie dient zur Kontaktierung der elektronischen Bauteile der Schaltungsanordnung. Außerhalb des Gehäusekörpers befindet sich mindestens ein Teilbereich der Leiterfolie, der als Kontaktstellen aufweisender Anschlußbereich zur Kontaktierung der Anschlußkontakte und/oder zur Kontaktierung der nicht im Gehäusekörper angeordneten weiteren elektronischen Bauteile der elektronischen Baugruppe dient. Im Gehäusekörper ist in der auf dem Trägerkörper aufliegenden Unterseite eine umlaufende Dichtung integriert (bsp. eingelegt oder eingespritzt), die die Dichtwirkung des Gehäusekörpers erhöht und damit den Schutz der vom Gehäusekörper umschlossenen elektronischen Bauteile vor äußeren Einflüssen verbessert.
- Als weitere elektronische Bauteile der elektronischen Baugruppe können Sensoren und/oder Aktoren vorgesehen werden, die an einer zur Realisierung ihrer Funktion geeigneten Stelle positioniert werden; insbesondere werden die Sensoren und/oder Aktoren auf dem Trägerkörper positioniert und/oder im Gehäusekörper integriert oder es werden am Trägerkörper und/oder Gehäusekörper Trägerelemente als Sensorträger und/oder Aktorträger zur Aufnahme der Sensoren und/oder Aktoren angebracht. Die Kontaktierung der weiteren elektronischen Bauteile (Sensoren und/oder Aktoren) erfolgt über die Kontaktstellen in den Anschlußbereichen der Leiterfolie, entweder durch direkte Verbindung dieser Kontaktstellen mit den Anschlüssen der Sensoren und/oder Aktoren oder durch indirekte Verbindung dieser Kontaktstellen mit den Anschlüssen der Sensoren und/oder Aktoren (bsp. über Stanzgitteranschlüsse eines Stanzgitters).

Die elektronischen Baugruppe vereinigt mehrere Vorteile in sich:
- Der Gehäusekörper kann außer zum Schutz der elektronischen Bauteile (Dichtungsfunktion) auch zur Positionierung der elektronischen Bauteile (Trägerfunktion) herangezogen werden.
- Die im Gehäusekörper angeordneten elektronischen Bauteile werden aufgrund der Dichtigkeit des Gehäusekörpers (die Leiterfolie wird direkt auf den Trägerkörper aufgebracht, an der Verbindungsstelle von Gehäusekörper und Trägerkörper ist im Gehäusekörper eine Dichtung integriert) und da auf der Leiterfolie angebrachten Leiterbahnen keine Kapillareffekte zulassen, vor externen Einflüssen, insbesondere vor dem Eindringen von fluiden Medien wirksam geschützt; die außerhalb des Gehäusekörpers angeordneten elektronischen Bauteile können durch geeignete Trägerelemente zur Aufnahme dieser elektronischen Bauteile (bsp. durch Sensorträger und/oder Aktorträger) vor externen Einflüssen geschützt werden. Somit können Beschädigungen der elektronischen Bauteile der elektronischen Baugruppe, insbesondere der elektronischen Bauteile der Schaltungsanordnung, und damit Beeinträchtigungen der Funktionsweise der elektronischen Baugruppe vermieden werden.
- Aufgrund der über die Leiterfolie erfolgenden elektrischen Anbindung der elektronischen Bauteile kann die Fläche des Schaltungsträgers für die Schaltungsanordnung gering gehalten werden und eine flexible Kontaktierung der elektronischen Bauteile realisiert werden, wodurch auch Änderungen (insbesondere im Aufbau der Schaltungsanordnung) schnell und kostengünstig umgesetzt werden können.

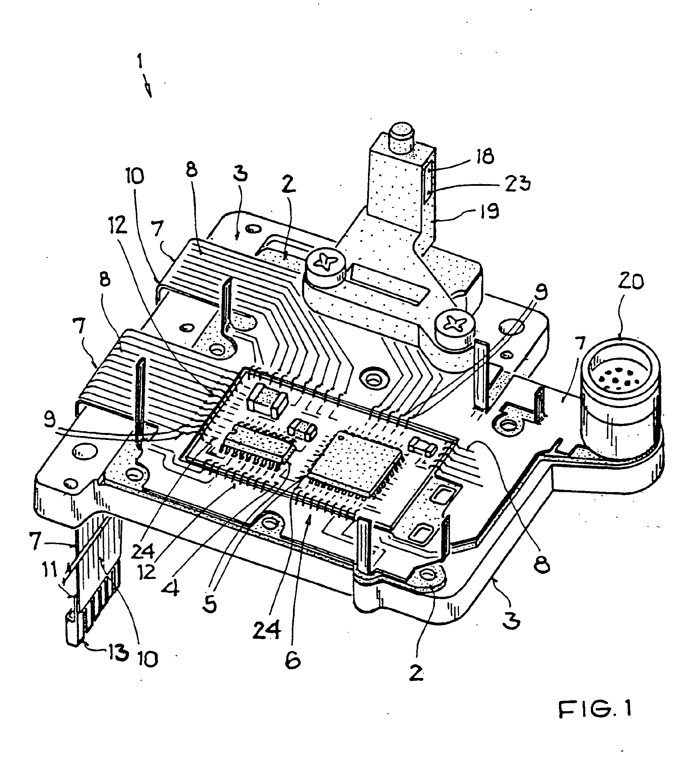

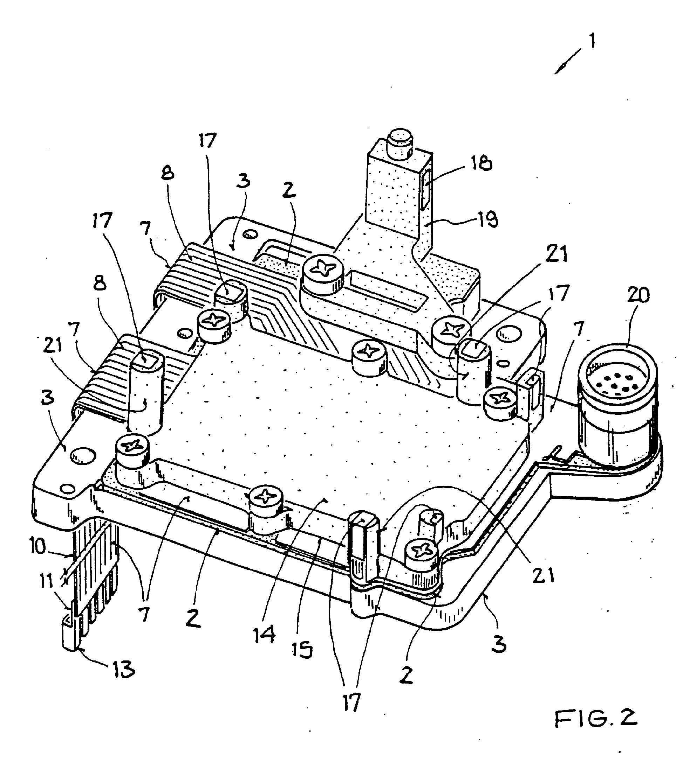

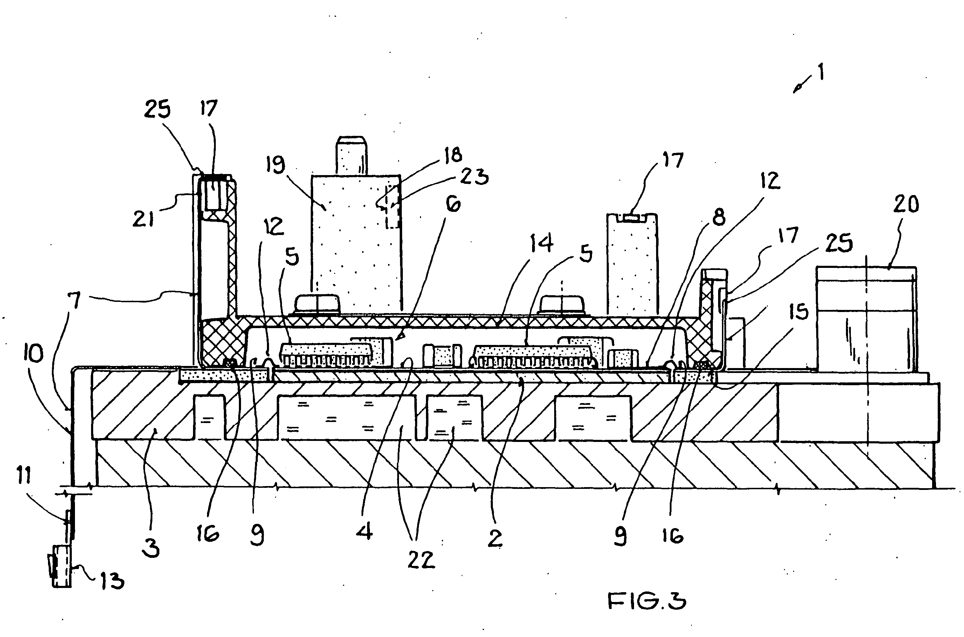

Im Zusammenhang mit der Zeichnung (Figuren 1 bis 3) soll die elektronische Baugruppe anhand eines Ausführungsbeispiels erläutert werden.
- Figur 1: zeigt eine dreidimensionale Ansicht der elektronischen Baugruppe ohne Gehäusekörper,
- Figur 2: zeigt eine dreidimensionale Ansicht der elektronischen Baugruppe mit Gehäusekörper,
- Figur 3: zeigt eine Schnittzeichnung der elektronischen Baugruppe.

Die elektronische Baugruppe 1 ist bsp. als Getriebesteuergerät für stufenlose Getriebe (CVT-Getriebe) von Kraftfahrzeugen ausgebildet. Das Sensoren 17, 18 zur Erfassung von für die Steuerung des Getriebes erforderlichen Meßwerten aufweisende Getriebesteuergerät 1 ist im Getriebe integriert und auf dem ein Bestandteil der Hydraulik des Getriebes bildenden, Ölkanäle 22 aufweisenden Kühlkörper 3 ("Kanalplatte") aufgebracht.
Das Getriebesteuergerät 1 besteht aus folgenden Komponenten:
- Einem bsp. aus Aluminium bestehenden Trägerkörper 2 mit den Abmessungen von bsp. 150 mm x 180 mm x 3 mm, der auf den Kühlkörper 3 (die Kanalplatte) mit den Abmessungen von bsp. 250 mm x 150 mm x 20 mm aufgebracht ist; da die Dicke des Trägerkörpers 2 mit bsp. 3 mm gering im Vergleich zur Dicke des Kühlkörpers 3 mit bsp. 20 mm ist, kann der Trägerkörper 2 im Herstellungsprozeß des Getriebesteuergeräts 1 gut gehandhabt werden (insbesondere bei thermischen Prozeßschritten). Erst am Ende des Herstellungsprozesses des Getriebesteuergeräts 1 wird der Trägerkörper 2 auf den mit dem Getriebe verbundenen Kühlkörper 3 aufgebracht, bsp. auf den Kühlkörper 3 aufgeschraubt.
- Einem bsp. als Keramiksubstrat (bsp. aus Al₂O₃) bestehenden Schaltungsträger 4 mit Verbindungsleitungen 24, der in einem Teilbereich des Trägerkörpers 2 auf den Trägerkörper 2 aufgebracht ist (bsp. auf den Trägerkörper 2 aufgeklebt ist); bsp. besitzt der Schaltungsträger 4 die Abmessungen von 100 mm x 70 mm x 1.5 mm.
- Auf dem Schaltungsträger 4 ist eine elektronische Bauteile 5 aufweisende Schaltungsanordnung 6 angeordnet, die zur Verarbeitung und Auswertung der Sensorsignale und der sich hieraus ergebenden Ansteuerung des Getriebes vorgesehen ist. Die Verlustleistung der elektronischen Bauteile 5 der Schaltungsanordnung 6 (insbesondere von Leistungshalbleiterbauteilen) wird über den Schaltungsträger 4, den Trägerkörper 2 und den Kühlkörper 3 ins mit Öl versorgte Getriebe abgeführt.
- Auf dem nicht vom Schaltungsträger 4 bedeckten Teilbereich des Trägerkörpers 2 ist weiterhin eine Leiterbahnen 8 und Kontaktstellen 9, 11 aufweisende Leiterfolie 7 aufgebracht, bsp. auf den Trägerkörper 2 auflaminiert; bsp. besitzt die Leiterfolie 7 die Abmessungen von 250 mm x 170 mm x 0.25 mm. An den Kontaktstellen 9 werden die elektronischen Bauteile 5 der Schaltungsanordnung 6 elektrisch leitend angeschlossen, bsp. über Bondverbindungen 12 von den Kontaktstellen 9 der Leiterfolie 7 zu den Anschlüssen der elektronischen Bauteile 5 der Schaltungsanordnung 6 oder zu den Verbindungsleitungen 24 auf dem Schaltungsträger 4; an den in den Anschlußbereichen 10 der Leiterfolie 7 vorgesehenen Kontaktstellen 11 werden Anschlußkontakte 13 angebracht, bsp. werden die Anschlußkontakte 13 an den Kontaktstellen 11 mit der Leiterfolie 7 verschweißt oder gecrimpt.
- Auf den Trägerkörper 2 ist ein Gehäusekörper 14 aufgesetzt und bsp. mit dem Trägerkörper 2 verschraubt oder mit dem Trägerkörper 2 vernietet; der insbesondere die elektronischen Bauteile 5 der Schaltungsanordnung 6 und einen Teilbereich der Leiterfolie 7 abdeckende Gehäusekörper 14 (die Anschlußbereiche 10 der Leiterfolie 7 sind außerhalb des Gehäusekörpers 14 angeordnet) besteht bsp. aus Kunststoff, bsp. aus Polybutylenterephthalat (PBT) oder aus Polyamid (PA) und besitzt bsp. die Abmessungen von 150 mm x 100 mm x 20 mm. Im Gehäusekörper 14 ist in der auf dem Trägerkörper 2 aufliegenden Unterseite 15 eine umlaufende Dichtung 16 integriert; diese bsp. als Formdichtung ausgebildete Dichtung 16 besteht bsp. aus einer Silikondichtmasse oder aus einem Fluor-Silicon-Kautschuk (MFQ, FVMQ) oder aus einem hydrierten Nitrilkautschuk (H-NBR).
- Mit dem Trägerkörper 2 verbunden sind mehrere in das Getriebe hineinragende Sensoren 17, 18 als weitere elektronische Bauteile des Getriebesteuergeräts 1. Die bsp. zur Erfassung von Magnetfeldern als Hallsensoren ausgebildeten Sensoren 17, 18 werden bsp. als Drehzahlsensoren zur Erfassung von Magnetfelddifferenzen, bsp. im Bereich von 1.7 mT bis 40 mT eingesetzt sowie als Wählhebelsensoren zur Erfassung des Absolutwerts der Flußdichte von Magnetfeldern, bsp. im Bereich von 0 mT bis 100 mT. Bsp. sind mehrere Sensoren 17 in Ausformungen 21 des Gehäusekörpers 14 integriert, insbesondere die Drehzahlsensoren; ein weiterer Sensor 18 ist in einem auf den Trägerkörper 14 aufgebrachten Sensorträger 19 eingebracht (Höhe des Sensorträgers 19 bsp. ca. 150 mm), bsp. in eine Aussparung 23 des Sensorträgers 19 bündig eingesetzt ("eingeklipst"). Die Kontaktierung der Sensoren 17, 18 erfolgt über die Leiterfolie 7, wobei die Kontaktstellen 25 der zu den Sensoren 17, 18 hingeführten Anschlußbereiche 10 der Leiterfolie 7 mit den Anschlüssen der Sensoren 17, 18 direkt verbunden werden, bsp. durch Verschweißen.
- Die mit den Kontaktstellen 11 verbundenen Anschlußkontakte 13 können zur Bildung von Steckeranschlüssen zusammengefaßt werden, an denen Anschlußstecker 20 zur Verbindung mit weiteren elektronischen Baugruppen und/oder Bauteilen und/oder zur Spannungsversorgung angeschlossen werden können; bsp. wird das Getriebesteuergerät 1 mit dem seitlich am Trägerkörper 2 gebildeten Anschlußstecker 20 mit dem Motorsteuergerät verbunden.

## Patentansprüche

1. Elektronische Baugruppe (1) mit
einem Trägerkörper (2),
einem auf dem Trägerkörper (2) angeordneten Schaltungsträger (4) zur Aufnahme einer Schaltungsanordnung (6) mit mindestens einem elektronischen Bauteil (5),
einer Leiterfolie (7) mit Leiterbahnen (8), wobei an Kontaktstellen (9, 11) der Leiterbahnen (8) Anschlußkontakte (13) zur Bildung von Anschlußsteckern (20) oder Kontaktverbindungen (12) zur Kontaktierung der elektronischen Bauteile (5) der Schaltungsanordnung (6) angeschlossen sind,
und einem auf den Trägerkörper (2) bündig aufgebrachten, zumindest die Schaltungsanordnung (6) umschließenden Gehäusekörper (14), **dadurch gekennzeichnet, dass** die elektronische Baugruppe (1) auf einem Ölkanäle (22) aufweisenden Kühlkörper (3) aufgebracht ist.

2. Elektronische Baugruppe nach Anspruch 1, **dadurch gekennzeichnet, daß** im Gehäusekörper (14) eine umlaufende Dichtung (15) integriert ist.

3. Elektronische Baugruppe nach Anspruch 1 oder 2, **dadurch gekennzeichnet, daß** die Dichtung (15) im Gehäusekörper (14) eingelegt oder eingespritzt ist.

4. Elektronische Baugruppe nach einem der Ansprüche 1 bis 3, **dadurch gekennzeichnet, daß** mindestens ein weiteres elektronisches Bauteil (17, 18) mit Kontaktstellen (25) der Leiterbahnen (8) der Leiterfolie (7) verbunden ist.

5. Elektronische Baugruppe nach einem der Ansprüche 1 bis 4, **dadurch gekennzeichnet, daß** mindestens ein weiteres elektronisches Bauteil (17) in eine Ausformung (21) des Gehäusekörpers (14) integriert ist.

6. Elektronische Baugruppe nach einem der Ansprüche 1 bis 4, **dadurch gekennzeichnet, daß** mindestens ein weiteres elektronisches Bauteil (18) in ein auf dem Trägerkörper (2) angebrachtes Trägerelement (19) integriert ist.

7. Elektronische Baugruppe nach Anspruch 6, **dadurch gekennzeichnet, daß** das mindestens eine weitere elektronische Bauteil (18) in einer Aussparung (23) des Trägerelements (19) eingesetzt ist.

8. Elektronische Baugruppe nach einem der Ansprüche 1 bis 7, **dadurch gekennzeichnet, daß** ein mindestens einen Anschlußbereich (10) aufweisender Teilbereich der Leiterfolie (7) außerhalb des Gehäusekörpers (14) angeordnet ist, und daß die Leiterbahnen (8) des mindestens einen Anschlußbereichs (10) Kontaktstellen (25) zur Bildung von Anschlußsteckern (20) und/oder zur Kontaktierung des mindestens einen weiteren elektronischen Bauteils (1 7, 18) aufweisen.

9. Elektronische Baugruppe nach einem der Ansprüche 1 bis 8, **dadurch gekennzeichnet, daß** die in den Anschlußbereichen (10) der Leiterfolie (7) gebildeten Kontaktstellen (11, 25) mit den Anschlußkontakten (13) und/oder mit den Anschlüssen des mindestens einen weiteren elektronischen Bauteils (17, 18) durch Löten oder Schweißen oder Crimpen elektrisch leitend verbunden sind.

10. Elektronische Baugruppe nach einem der Ansprüche 1 bis 9, **dadurch gekennzeichnet, daß** der Gehäusekörper (14) aus Polybutylenterephthalat oder Polyamid besteht.

11. Elektronische Baugruppe nach einem der Ansprüche 1 bis 10, **dadurch gekennzeichnet, daß** der Trägerkörper (2) auf einem Kühlkörper (3) angeordnet ist.

12. Elektronische Baugruppe nach einem der Ansprüche 4 bis 11, **dadurch gekennzeichnet, daß** mindestens ein weiteres elektronisches Bauteil (1 7, 18) als Hallsensor ausgebildet ist.

## Claims

1. An electronic assembly (1) with
a carrier body (2),
a circuit carrier (4) for retaining a circuit arrangement (6) arranged on said carrier body (2) with at least one electronic component (5),
a conductor foil (7) with conductor tracks (8), wherein on contact points (9, 11) of the conductor tracks (8), connection contacts (13) are connected for the formation of connectors (20) or contacts (12) for contacting the electronic components (5) of the circuit arrangement (6),
and a housing body (14) which is brought flush onto the carrier body (2), and encompassing at least the circuit arrangement (6), **characterized in that the** electronic assembly (1) is brought onto a cooling body (3) which comprises oil ducts (22).

2. An electronic assembly according to claim 1, **characterized in that** in the housing body (14), an encompassing seal (15) is integrated.

3. An electronic assembly according to either of claims 1 or 2, **characterized in that** the seal (15) is inserted or injected into the housing body (14).

4. An electronic assembly according to any one of claims 1 to 3, **characterized in that** at least one further electronic component (17, 18) is connected to contact points (25) of the conductor tracks (8) of the conductor foil (7).

5. An electronic assembly according to any one of claims 1 to 4, **characterized in that** at least one further electronic component (17) is integrated into a mould (21) of the housing body (14).

6. An electronic assembly according to any one of claims 1 to 4, **characterized in that** at least one further electronic component (18) is integrated into a carrier element (19) which is brought onto the carrier body (2).

7. An electronic assembly according to claim 6, **characterized in that** the at least one further electronic component (18) is inserted into a recess (23) of the carrier element (19).

8. An electronic assembly according to any one of claims 1 to 7, **characterized in that** a partial section of the conductor foil (7) which comprises at least one connection section (10) is arranged outside of the housing body (14), and that the conductor tracks (8) of at least one connection section (10) comprise contact points (25) for the formation of connectors (20) and/or for contacting the at least one further electronic component (17, 18).

9. An electronic assembly according to any one of claims 1 to 8, **characterized in that** the contact points (11, 25) which are formed in the connection sections (10) of the conductor foil (7) are connected in an electrically conducting manner with the connection contacts (13) and/or with the contacts of the at least one further electronic component (17, 18) by means of soldering or welding or crimping.

10. An electronic assembly according to any one of claims 1 to 9, **characterized in that** the housing body (14) consists of polybutylene terephthalate or polyamide.

11. An electronic assembly according to any one of claims 1 to 10, **characterized in that** the carrier body (2) is arranged on a cooling body (3).

12. An electronic assembly according to any one of claims 4 to 11, **characterized in that** at least one further electronic component (17, 18) is designed as a Hall sensor.

## Revendications

1. Module électronique (1) avec
un corps support (2),
un support de circuit (4) disposé sur le corps support (2) pour l'accueil d'un agencement de circuit (6) avec au moins un composant électronique (5),
un film conducteur (7) avec pistes conductrices (8), des contacts de branchement (13) étant raccordés aux points de contact (9, 11) des pistes conductrices (8) pour la formation de fiches de connexion (20) ou de liaisons de contact (12) pour la connexion des composants électroniques (5) de l'agencement de circuit (6),
et un corps de boîtier (14) disposé de façon arasée sur le corps support (2), au moins entourant l'agencement de circuit (6), **caractérisé en ce que** le module électronique (1) est disposé sur un dissipateur thermique (3) présentant des canaux d'huile (22).

2. Module électronique selon la revendication 1, **caractérisé en ce qu'**un joint sur la circonférence (15) est intégré dans le corps de boîtier (14).

3. Module électronique selon la revendication 1 ou 2, **caractérisé en ce que** le joint (15) est inséré ou injecté dans le corps de boîtier (14).

4. Module électronique selon l'une des revendications 1 à 3, **caractérisé en ce qu'**au moins un autre module électronique (17, 18) est relié avec des points de contact (25) des pistes de conductrices (8) du film conducteur (7).

5. Module électronique selon l'une des revendications 1 à 4, **caractérisé en ce qu'**au moins un autre module électronique (17) est intégré dans un évidement (21) du corps de boîtier (14).

6. Module électronique selon l'une des revendications 1 à 4, **caractérisé en ce qu'**au moins un autre module électronique (18) est intégré dans un élément support (19) disposé sur le corps support (2).

7. Module électronique selon la revendication 6, **caractérisé en ce qu'**au moins un autre module électronique (18) est intégré dans un évidement (23) de l'élément support (19).

8. Module électronique selon l'une des revendications 1 à 7, **caractérisé en ce qu'**une zone partielle du film conducteur (7), présentant au moins une zone de connexion (10), est disposée à l'extérieur du corps de boîtier (14) et **en ce que** les pistes conductrices (8) de l'au moins une zone de connexion (10) présentent des points de contact (25) pour la formation de fiches de connexion (20) et/ou pour la connexion de l'au moins un autre module électronique (17, 18).

9. Module électronique selon l'une des revendications 1 à 8, **caractérisé en ce que** les points de contact (11, 25) formés dans les zones de connexion (10) du film conducteur (7) sont reliés aux contacts de branchement (13) et/ou aux bornes de l'au moins un autre module électronique (17, 18) par soudage ou par brasage ou par sertissage, de façon électriquement conductrice.

10. Module électronique selon l'une des revendications 1 à 9, **caractérisé en ce que** le corps de boîtier (14) est en téréphtalate de polybutylène ou en polyamide.

11. Module électronique selon l'une des revendications 1 à 10, **caractérisé en ce que** le corps support (2) est disposé sur un dissipateur thermique (3).

12. Module électronique selon l'une des revendications 4 à 11, **caractérisé en ce qu'**au moins un autre module électronique (17, 18) est formé comme capteur à effet Hall.
